# EUROPEAN PATENT APPLICATION

(11) **EP 3 664 140 A1**
(43) Date of publication of application: **10.06.2020**
(21) Application number: 19162552.4
(22) Date of filing: 13.03.2019
(51) Int. Cl.: H01L 27/146

(54) **IMAGE CAPTURING MODULE AND PORTABLE ELECTRONIC DEVICE**

(30) Priority: 05.12.2018 TW 107143675
(71) Applicant: Azurewave Technologies, Inc., 231 New Taipei City (TW)
(72) Inventor: JIN, Chuan, Ying zhong town, Zhongxiang, Hubei (CN)
(74) Representative: Viering, Jentschura & Partner mbB Patent- und Rechtsanwälte

(57) **Abstract**

An image capturing module (M) and a portable electronic device (Z). An image capturing module (M) includes a circuit substrate (1), an image sensing chip (2), a filter element (3), and a lens assembly (4). The circuit substrate (1) has an upper surface (11), a lower surface (12), and a through opening (13). The image sensing chip (2) is placed on the lower surface (12) of the circuit substrate (1) and below the through opening (13). The filter element (3) is placed on the upper surface (11) of the circuit substrate (1) and above the through opening (13). The lens assembly (4) includes a holding structure (41) and a lens structure (42). The lower surface (12) of the circuit substrate (1) includes a first solder area (14), a second solder area (15), and a first solderless area (16). The upper surface (21) of the image sensing chip (2) includes an image sensing area (22), a first conductive area (23), a second conductive area (24), and a first non-conductive area (25).

## Description

This application claims the benefit of priority to Taiwan Patent Application No. 107143675, filed on December 05, 2018. The entire content of the above identified application is incorporated herein by reference.

Some references, which may include patents, patent applications and various publications, may be cited and discussed in the description of this disclosure. The citation and/or discussion of such references is provided merely to clarify the description of the present disclosure and is not an admission that any such reference is "prior art" to the disclosure described herein. All references cited and discussed in this specification are incorporated herein by reference in their entireties and to the same extent as if each reference was individually incorporated by reference.

### FIELD OF THE DISCLOSURE

The present disclosure relates to an image capturing module and a portable electronic device, and more particularly to an image capturing module and a portable electronic device for reducing the width of an image sensor.

### BACKGROUND OF THE DISCLOSURE

In the conventional technology pertaining to related art, the special advantage of Complementary Metal-Oxide-Semiconductor (CMOS) image sensors is characterized by "low power consumption" and "small volume". Therefore, CMOS image sensors can be easily integrated into portable electronic products with special requirements. For example, CMOS image sensors can be easily integrated into portable electronic products with small integration space, such as smart phones, tablets or notebooks, etc.

However, the width of conventional CMOS image sensors still cannot be effectively shortened. Therefore, how the width of the conventional CMOS image sensor can be effectively shortened by making improvements to the structural design thereof has become an important issue in the industry.

### SUMMARY OF THE DISCLOSURE

In response to the above-referenced technical inadequacies, the present disclosure provides an image capturing module and a portable electronic device.

In one aspect, the present disclosure provides an image capturing module, including a circuit substrate, an image sensing chip, a filter element, and a lens assembly. The circuit substrate has an upper surface, a lower surface, and a through opening connecting the upper surface and the lower surface. The image sensing chip is disposed on the lower surface of the circuit substrate and below the through opening. The filter element is disposed on the upper surface of the circuit substrate and above the through opening. The lens assembly includes a holding structure disposed on the circuit substrate and a lens structure disposed on the holding structure. The lower surface of the circuit substrate includes a first solder area adjacent to a first side of the through opening, a second solder area adjacent to a second side of the through opening, and a first solderless area adjacent to a third side of the through opening. The upper surface of the image sensing chip includes an image sensing area, a first conductive area, a second conductive area, and a first non-conductive area. The first conductive area is connected between a first side of the image sensing chip and a first side of the image sensing area. The second conductive area is connected between a second side of the image sensing chip and a second side of the image sensing area. The first non-conductive area is connected between a third side of the image sensing chip and a third side of the image sensing area. The first solder area of the image sensing chip and the second solder area are electrically and respectively connected to the first conductive area and the second conductive area of the circuit substrate, and the first solderless area of the image sensing chip corresponds to the first non-conductive area of the circuit substrate.

In one aspect, the present disclosure provides a portable electronic device, including a portable electronic device and an image capturing module. The image capturing module is disposed on the portable electronic module, and the image capturing module includes a circuit substrate, an image sensing chip, a filter element, and a lens assembly. The circuit substrate has an upper surface, a lower surface, and a through opening connecting the upper surface and the lower surface. The image sensing chip is disposed on the lower surface of the circuit substrate and below the through opening. The filter element is disposed on the upper surface of the circuit substrate and above the through opening. The lens assembly includes a holding structure disposed on the circuit substrate and a lens structure disposed on the holding structure. The lower surface of the circuit substrate includes a first solder area adjacent to a first side of the through opening, a second solder area adjacent to a second side of the through opening, and a first solderless area adjacent to a third side of the through opening. The upper surface of the image sensing chip includes an image sensing area, a first conductive area, a second conductive area, and a first non-conductive area. The first conductive area is connected between a first side of the image sensing chip and a first side of the image sensing area. The second conductive area is connected between a second side of the image sensing chip and a second side of the image sensing area. The first non-conductive area is connected between a third side of the image sensing chip and a third side of the image sensing area. The first solder area of the image sensing chip and the second solder area are electrically and respectively connected to the first conductive area and the second conductive area of the circuit substrate, and the first solderless area of the image sensing chip corresponds to the first non-conductive area of the circuit substrate.

In one aspect, the present disclosure provides another image capturing module, including a circuit substrate, an image sensing chip, a filter element, and a lens assembly. The circuit substrate has an upper surface, a lower surface, and a through opening connecting the upper surface and the lower surface. The image sensing chip is disposed on the lower surface of the circuit substrate and below the through opening. The filter element is disposed on the upper surface of the circuit substrate and above the through opening. The lens assembly includes a holding structure disposed on the circuit substrate and a lens structure disposed on the holding structure. The lower surface of the circuit substrate includes a first solder area adjacent to a first side of the through opening and a first solderless area adjacent to a second side of the through opening. The upper surface of the image sensing chip includes an image sensing area, a first conductive area, and a first non-conductive area. The first conductive area is connected to a first side of the image sensing chip and a first side of the image sensing area. The first non-conductive area is connected between a second side of the image sensing chip and a second side of the image sensing area. The first solder area of the image sensing chip is electrically connected to the first conductive area of the circuit substrate respectively through a first solder ball, and the first solderless area of the image sensing chip is connected to the first non-conductive area of the circuit through a first adhesive.

Therefore, one of the beneficial effects of the present disclosure is that the image capturing module and the portable electronic device provided by the present disclosure can adopt the technical features of "the lower surface of the circuit substrate including a first solder area adjacent to a first side of the through opening, a second solder area adjacent to a second side of the through opening, and a first solderless area adjacent to a third side of the through opening", "the upper surface of the image sensing chip including an image sensing area, a first conductive area, a second conductive area, and a first non-conductive area; the first conductive area being connected between a first side of the image sensing chip and a first side of the image sensing area, and the second conductive area being connected to a second side of the image sensing chip and a second side of the image sensing area; and the first non-conductive area being connected between a third side of the image sensing chip and a third side of the image sensing area", and "the first conductive area of the image sensing chip and the second conductive area being electrically and respectively connected to the first solder area and the second solder area of the circuit substrate, and the first non-conductive area of the image sensing chip corresponding to the first solderless area of the circuit substrate", so as to reduce the width or size of the image sensing chip in the horizontal direction.

Another beneficial effect of the present disclosure is that the image capturing module provided by the present disclosure can adopt the technical features of "the lower surface of the circuit substrate including a first solder area adjacent to a first side of the through opening and a first solderless area adjacent to a second side of the through opening", "the upper surface of the image sensing chip including an image sensing area, a first conductive area, and a first non-conductive area; the first conductive area being connected to a first side of the image sensing chip and a first side of the image sensing area, and the first non-conductive area being connected between a second side of the image sensing chip and a second side of the image sensing area", and "the first conductive area of the image sensing chip being electrically connected to the first solder area of the circuit substrate through a first solder ball, and the first non-conductive area of the image sensing chip being connected to the first solderless area of the circuit substrate through a first adhesive", so as to reduce the width or size of the image sensing chip in the horizontal direction.

These and other aspects of the present disclosure will become apparent from the following description of the embodiment taken in conjunction with the following drawings and their captions, although variations and modifications therein may be affected without departing from the spirit and scope of the novel concepts of the disclosure.

### BRIEF DESCRIPTION OF THE DRAWINGS

The present disclosure will become more fully understood from the following detailed description and accompanying drawings.
FIG. 1 is a top view of an image sensing chip of an image capturing module according to a first embodiment of the present disclosure.
FIG. 2 is a bottom view of the image sensing chip of the image capturing module according to the first embodiment of the present disclosure.
FIG. 3 is a cross-sectional view of the image capturing module according to the first embodiment of the present disclosure.
FIG. 4 is a top view of an image sensing chip of an image capturing module according to a second embodiment of the present disclosure.
FIG. 5 is a bottom view of the image sensing chip of the image capturing module according to the second embodiment of the present disclosure.
FIG. 6 is a first top view of an image sensing chip of an image capturing module according to a third embodiment of the present disclosure.
FIG. 7 is a first bottom view of the image sensing chip of the image capturing module according to the third embodiment of the present disclosure.
FIG. 8 is a second top view of an image sensing chip of an image capturing module according to a fourth embodiment of the present disclosure.
FIG. 9 is a second bottom view of the image sensing chip of the image capturing module according to the fourth embodiment of the present disclosure.
FIG. 10 is a schematic view of a portable electronic device of ccording to a fifth embodiment of the present disclosure.

### DETAILED DESCRIPTION OF THE EXEMPLARY EMBODIMENTS

The present disclosure is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a", "an", and "the" includes plural reference, and the meaning of "in" includes "in" and "on". Titles or subtitles can be used herein for the convenience of a reader, which shall have no influence on the scope of the present disclosure.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present disclosure or of any exemplified term. Likewise, the present disclosure is not limited to various embodiments given herein. Numbering terms such as "first", "second" or "third" can be used to describe various components, signals or the like, which are for distinguishing one component/signal from another one only, and are not intended to, nor should be construed to impose any substantive limitations on the components, signals or the like.

### [First Embodiment]

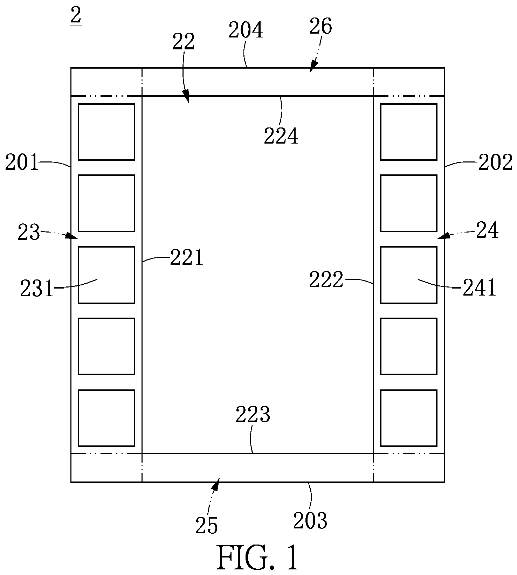

Referring to FIG. 1 to FIG. 3, a first embodiment of the present disclosure provides an image capturing module M, including a circuit substrate 1, an image sensing chip 2, a filter element 3, and a lens assembly 4.

Firstly, the circuit substrate 1 has an upper surface 11 and a lower surface 12, and the circuit substrate 1 has a through opening 13 connecting the upper surface 11 and the lower surface 12. Further, the lower surface 12 of the circuit substrate 1 may include a first solder area 14 adjacent to a first side 131 of the through opening 13, a second solder area 15 adjacent to a second side 132 of the through opening 13, and a first solderless area 16 adjacent to a third side 133 of the through opening 13. For example, the circuit substrate 1 may be a PCB hard board (such as BT, FR4, FR5 material), a soft and hard bonding board or a ceramic substrate, etc., but the present disclosure is not limited thereto.

Secondly, the image sensing chip 2 is electrically connected to the circuit substrate 1 , and the image sensing chip 2 is disposed on the lower surface 12 of the circuit substrate 1 and below the through opening 13. Further, the upper surface 21 of the image sensing chip 2 includes an image sensing area 22, a first conductive area 23, a second conductive area 24, and a first non-conductive area 25. The first conductive area 23 is connected between a first side 201 of the image sensing chip 2 and a first side 221 of the image sensing area 22, the second conductive area 24 is connected between a second side 202 of the image sensing chip 2 and a second side 222 of the image sensing area 22, and the first non-conductive area 25 is connected between a third side 203 of the image sensing chip 2 and a third side 223 of the image sensing area 22. The image sensing area 22 of the image sensing chip 2 faces the through opening 13 of the circuit substrate 1. For example, the image sensing chip 2 can be a complementary metal oxide semiconductor (CMOS) sensor or any sensor having an image capturing function, but the present disclosure is not limited thereto.

Therefore, the image sensing chip 2 can be electrically and respectively connected to the first solder area 14 and the second solder area 15 of the circuit substrate 1 through the first conductive area 23 and the second conductive area 24, and the first non-conductive area 25 of the image sensing chip 2 corresponds to the first solderless area 16 of the circuit substrate 1.

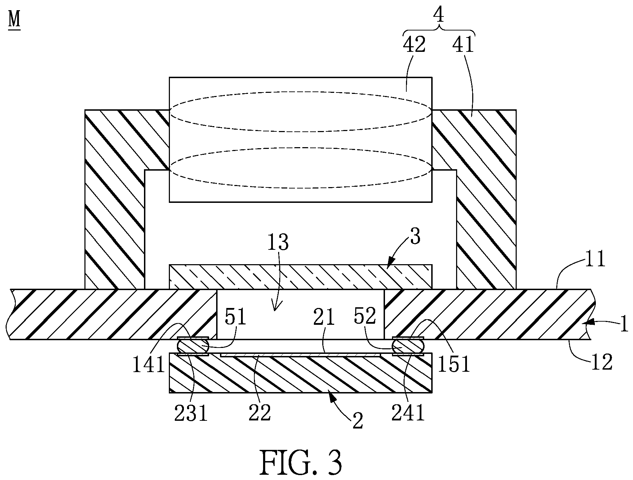

The image capturing module M further includes a filter element 3 disposed on the upper surface 11 of the circuit substrate 1 and located above the through opening 13. For example, the filter element 3 can be directly disposed on the image sensing chip 2 through an adhesive (as shown in FIG. 3), or the filter element 3 can be placed above the image sensing chip 2 by a plurality of pillars (not shown). In addition, the filter element 3 may be a coated glass or a non-coated glass, but the present disclosure is not limited thereto.

The image capturing module M also further includes: a lens assembly 4 including a holding structure 41 disposed on the circuit substrate 1 and a lens structure 42 disposed on the holding structure 41. For example, the holding structure 41 may be a common base or any kind of voice coil motor (VCM), the lens structure 42 may be composed of a plurality of lenses and corresponds to the image sensing area 22, and the lens structure 42 may be fixedly or movably disposed on the non-holding structure 41 according to different usage requirements, but the present disclosure is not limited thereto. In addition, the holding structure 41 may be disposed on the upper surface 101 of the circuit substrate 1 by an adhesive (not shown), but the present disclosure is not limited thereto.

In summary, since two sides of the circuit substrate 1 and the image sensing chip 2 can be provided with the first solder area 14, the second solder area 15, the first conductive area 23, and the second conductive area 24 to be electrically connected to each other, the width or size in the horizontal direction of the other sides of the circuit substrate 1 and the image sensing chip 2 can be reduced. That is, since the solder area and the conductive area can be omitted on the other sides of the circuit substrate 1 and the image sensing chip 2, the width of the circuit substrate 1 and the image sensing chip 2 in the horizontal direction (X direction) can be reduced. Therefore, the size of the image sensing chip 2 in the horizontal direction is reduced.

Further, the first solder area 14 may include a plurality of first solder pads 151, the second solder area 15 may include a plurality of second solder pads 151, the first conductive area 23 may include a plurality of first conductive parts 231, and the second conductive area 24 may include a plurality of second conductive parts 241. The first conductive parts 231 are electrically connected to the plurality of first solder pads 141 respectively through a plurality of first solder balls 51, and the plurality of second conductive parts 241 are electrically connected to the plurality of second solder pads 151 respectively through the plurality of second solder balls 52. The first solder area 14 is disposed opposite to the second solder area 15, and the first solderless area 16 is disposed between the first solder area 14 and the second solder area 15. For example, a plurality of first solder pads 141 may be disposed on the first solder area 14 of the circuit substrate 1, and a plurality of first solder pads 151 may be disposed on the second solder area 15. In contrast, a plurality of first conductive parts 231 may be disposed on the first conductive area 23 of the image sensing chip 2, and a plurality of second conductive parts 241 may be disposed on the second conductive area 24. Therefore, the plurality of first conductive parts 231 of the image sensing chip 2 are electrically connected to the plurality of first solder pads 141 respectively through the plurality of first solder balls 51, and the plurality of second conductive parts 241 are electrically connected to the plurality of second solder pads 151 respectively through the plurality of second solder balls 52.

It should be noted that, the lower surface 12 of the circuit substrate 1 includes a second solderless area 17 adjacent to a fourth side 134 of the through opening 13, and the upper surface 21 of the image sensing chip 2 includes a second non-conductive area 26 connected between a fourth side 204 of the image sensing chip 2 and a fourth side 224 of the image sensing area 22. The second non-conductive area 26 of the image sensing chip 2 corresponds to the second solderless area 17 of the circuit substrate 1. A first adhesive is disposed between the first solderless area 16 and the first non-conductive area 25, and a second adhesive is disposed between the second solderless area 17 and the second non-conductive area 26. The first solder area 14 is disposed opposite to the second solder area 15, the first solderless area 16 is disposed opposite to the second solderless area 17, and the first solderless area 16 and the second solderless area 17 are disposed between the first solder area 14 and the second solder area 15.

For example, the second solderless area 17 of the circuit substrate 1 is opposite to the first solderless area 16, the second non-conductive area 26 of the image sensing chip 2 is opposite to the first non-conductive area 25, and the second non-conductive area 26 of the image sensing chip 2 corresponds to the second solderless area 17 of the circuit substrate 1. Therefore, the first non-conductive area 25 of the image sensing chip 2 can be connected to the first solderless area 16 of the circuit substrate 1 through a first adhesive (not shown), and the second non-conductive area 26 of the image sensing chip 2 can be connected to the second solderless area 17 through the second adhesive (not shown). The first adhesive and the second adhesive may be adhesives made of epoxy or silicone, UV glue, thermosetting adhesives or AB glue.

However, the above-mentioned embodiment of the present disclosure is for exemplary purposes only and the present disclosure is not limited thereto.

### [Second Embodiment]

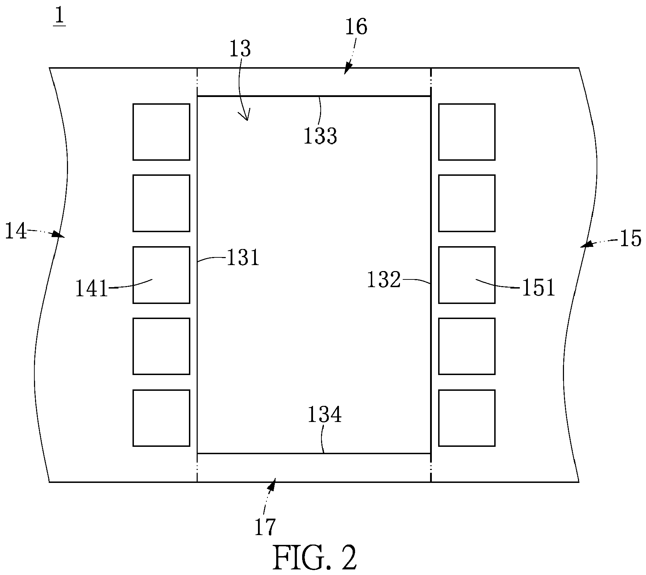

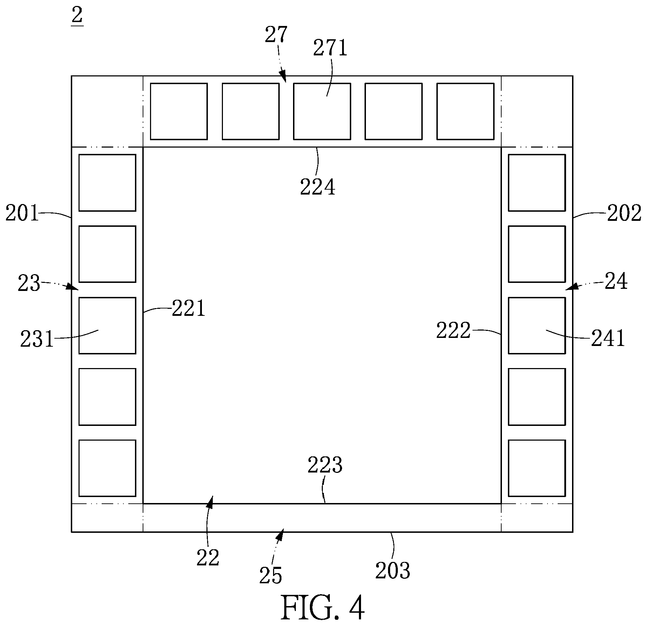

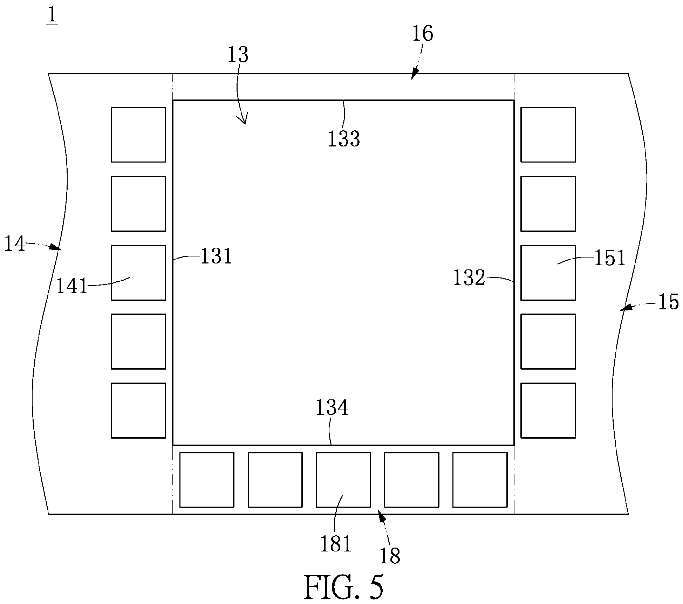

Referring to FIG. 4 to FIG. 5, a second embodiment of the present disclosure provides an image capturing module M, including: a circuit substrate 1, an image sensing chip 2, a filter element 3, and a lens assembly 4. Comparing FIG. 4 and FIG. 5 with FIG. 1 and FIG. 2, the biggest difference between the second embodiment and the first embodiment of the present disclosure is that, the lower surface 12 of the circuit substrate 1 includes a third solder area 18 adjacent to a fourth side 134 of the through opening 13, the upper surface 21 of the image sensing chip 2 includes a third conductive area 27 connected between a fourth side 204 of the image sensing chip 2 and a fourth side 224 of the image sensing area 22, and the third conductive area 27 of the image sensing chip 2 is electrically connected to the third solder area 18 of the circuit substrate 1. The third solder area 18 includes a plurality of third solder pads 181, and the third conductive area 271 includes a plurality of third conductive portions 271 electrically connected to the plurality of third solder pads 181 respectively through a plurality of third solder balls. The first solder area 14 is disposed opposite to the second solder area 15, the third solder area 18 is disposed opposite to the first solderless area 16, and the third solder area 18 and the first solderless area 16 are disposed between the first solder area 14 and the second solder area 15.

For example, the present disclosure may provide a third solder area 18 adjacent to the fourth side 134 of the through opening 13 and a third conductive area 27 between the fourth side 204 of the image sensing chip 22 and the fourth side 224 of the image sensing area 22 according to different design requirements. Further, the lower surface 12 of the circuit substrate 1 of the image capturing module M of the present embodiment includes a third solder area 18, a plurality of third solder pads 181 that may be disposed on the third solder area 18, and the third solder area 18 disposed opposite the first solderless area 16 and disposed between the first solder area 14 and the second solder area 15. The upper surface 21 of the image sensing chip 2 includes a third conductive area 27, a plurality of third conductive portions 271 disposed on the third conductive area 27, and the third conductive area 27 disposed opposite to the first non-conductive area 25 and between the first conductive area 23 and the second conductive area 24. The plurality of third conductive portions 271 of the image sensing chip 2 may be electrically connected to the plurality of third solder pads 181 through a plurality of third solder balls (not shown, similar to the arrangement of the first solder ball 51 and the second solder ball 52 shown in FIG. 3).

However, the above-mentioned embodiment of the present disclosure is for exemplary purposes only and the present disclosure is not limited thereto.

### [Third embodiment]

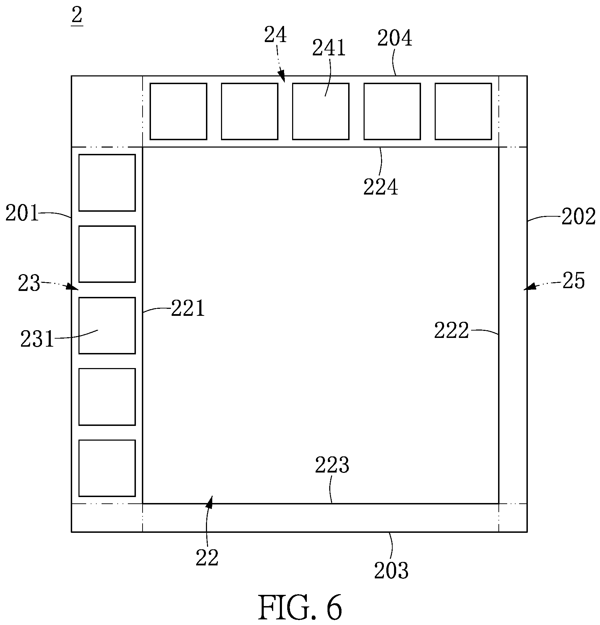

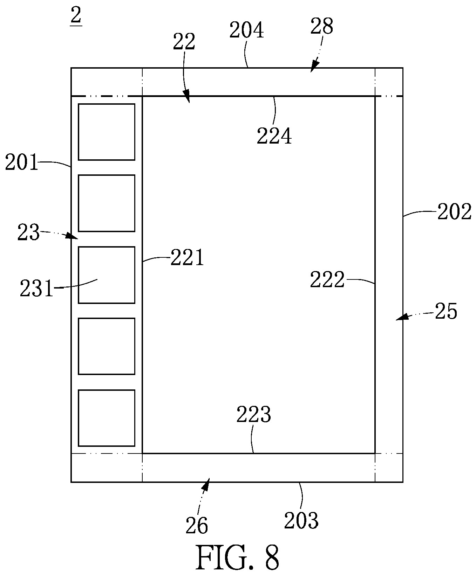

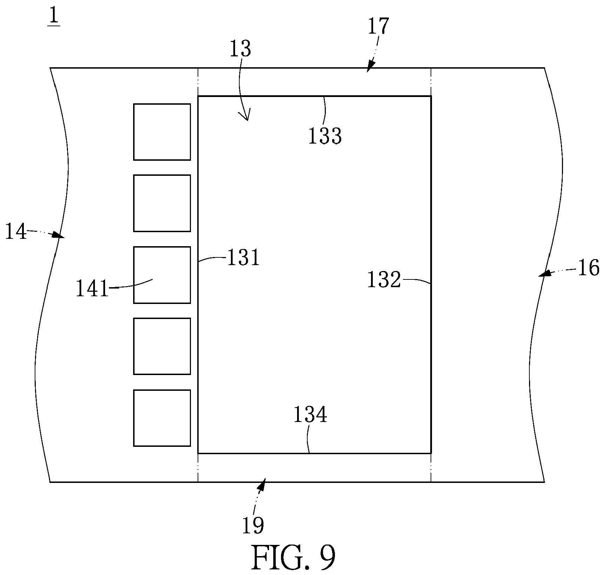

Referring to FIG. 6 to FIG. 9, a third embodiment of the present disclosure provides an image capturing module M, including: a circuit substrate 1, an image sensing chip 2, a filter element 3, and a lens assembly 4. Comparing FIG. 8 and FIG. 9 with FIG. 1 and FIG. 2, the biggest difference between the third embodiment and the first embodiment of the present disclosure is that, the lower surface 12 of the circuit substrate 1 includes a first solder area 14 adjacent to a first side 131 of the through opening 13 and a first solderless area 16 adjacent to a second side 132 of the through opening 13. The upper surface 21 of the image sensing chip 2 includes an image sensing area 22, a first conductive area 23, and a first non-conductive area 25. The first conductive area 23 is connected between a first side 201 of the image sensing chip 2 and a first side 221 of the image sensing area 22, and the first non-conductive area 25 is connected between a second side 202 of the image sensing chip 2 and a second side 222 of the image sensing area 22. The first conductive area 23 of the image sensing chip 2 is electrically connected to the first solder area 14 of the circuit substrate 1 through a first solder ball 51, and the first non-conductive area 25 of the image sensing chip 2 is connected to the first solderless area 16 of the circuit substrate 1 through a first adhesive.

For example, the present disclosure can provide a first solderless area 16 disposed adjacent to the second side 132 of the through opening 13, and a first non-conductive area 25 disposed between the second side 202 of the image sensing chip 2 and the second side 222 of the image sensing area 22 according to different design requirements. Further, the first conductive area 23 of the image sensing chip 2 is electrically connected to the first solder area 14 of the circuit substrate 1 through the first solder ball 51 (shown in FIG. 3), and the first non-conductive area 25 of the image sensing chip 2 is connected to the first solderless area 16 of the circuit substrate 1 through the first adhesive.

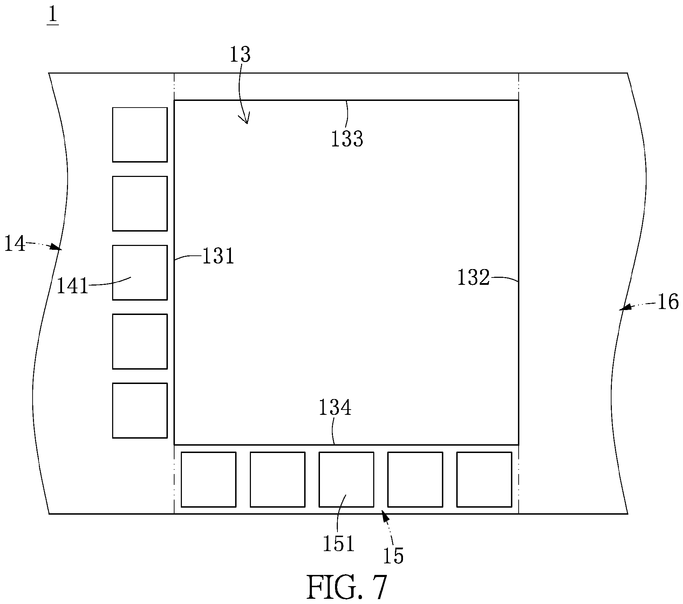

Furthermore, referring to FIG. 6 and FIG. 7, one of the configurations of the image capturing module M of the third embodiment of the present disclosure is shown. Further, the image sensing chip 2 of the image capturing module M of the fifth embodiment of the present disclosure can be designed to be in an eccentric configuration. For example, the lower surface 12 of the circuit substrate 1 of the image capturing module M includes a second solder area 15 adjacent to a fourth side 134 of the through opening 13, and the second solder area 15 is located between the first solder area 14 and the first solderless area 16. The upper surface 21 of the image sensing chip 2 includes a second conductive area 24 connected between a fourthside 204 of the image sensing chip 2 and a fourth side 224 of the image sensing area 22, and the second conductive area 24 of the image sensing chip 2 is electrically connected to the second solder area 15 of the circuit substrate 1 through a second solder ball 52 (shown in FIG. 3).

In addition, referring to FIG. 8 and FIG. 9, another configuration of the image capturing module M of the third embodiment of the present disclosure is shown. The lower surface 12 of the circuit substrate 1 may further include a second solderless area 17 adjacent to a third side 133 of the through opening 13 and a third solderless area 19 adjacent to a fourth side 134 of the through opening 13. The upper surface 21 of the image sensing chip 2 includes a second non-conductive area 26 and a third non-conductive area 28. The second non-conductive area 26 is connected between a third side 203 of the image sensing chip 2 and a third side 223 of the image sensing area 22, and the third non-conductive area 28 is connected between a fourth side 204 of the image sensing chip 2 and a fourth side 224 of the image sensing area 22. The second non-conductive area 26 of the image sensing chip 2 is connected to the third solderless area 17 of the circuit substrate 1 via a second adhesive, and the third non-conductive area 28 of the image sensing chip 2 is connected to the third solderless area 19 of the circuit substrate 1 through a third adhesive.

However, the above-mentioned embodiment of the present disclosure is for exemplary purposes only and the present disclosure is not limited thereto.

### [Fourth embodiment]

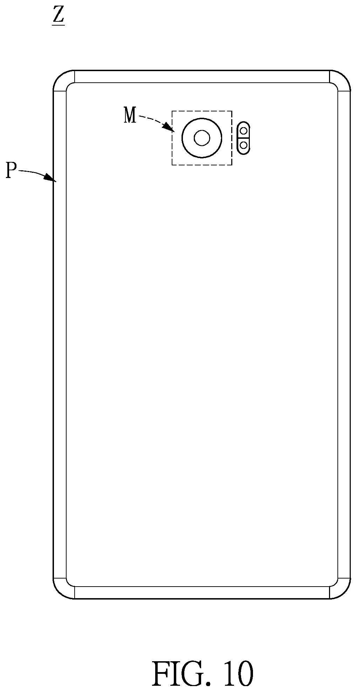

Referring to FIG. 10 and in conjunction with FIG. 1 to FIG. 9, a fourth embodiment of the present disclosure provides a portable electronic device Z, including: a portable electronic module P and an image capturing module M. The image capturing module M is disposed on the portable electronic module P, and the image capturing module P includes: a circuit substrate 1, an image sensing chip 2, a filter element 3, and a lens assembly 4. For example, the portable electronic module P can be a mobile phone, a notebook computer or a tablet computer, but the present disclosure is not limited thereto; any of the image capturing modules M in the first embodiment to the third embodiment can be installed in the portable electronic module P, so that the electronic module P can perform image capturing through the image capturing module M.

However, the above-mentioned embodiment of the present disclosure is for exemplary purposes only and the present disclosure is not limited thereto.

In conclusion, one of the beneficial effects of the present disclosure is that the image capturing module M and the portable electronic device P provided by the present disclosure can adopt the technical features of "the lower surface 12 of the circuit substrate 1 being capable of including a first solder area 14 adjacent to a first side 131 of the through opening 13, a second solder area 15 adjacent to a second side 132 of the through opening 13, and a first solderless area 16 adjacent to a third side 133 of the through opening 13", "the upper surface 21 of the image sensing chip 2 including an image sensing area 22, a first conductive area 23, a second conductive area 24, and a first non-conductive area 25; the first conductive area 23 being connected between a first side 201 of the image sensing chip 2 and a first side 221 of the image sensing area 22, the second conductive area 24 being connected between a second side 202 of the image sensing chip 2 and a second side 222 of the image sensing area 22, and the first non-conductive area 25 being connected between a third side 203 of the image sensing chip 2 and a third side 223 of the image sensing area 22", and "the first conductive area 23 and the second conductive area 24 being electrically and respectively connected to the first solder area 14 and the second solder area 15 of the circuit substrate 1, and the first non-conductive area 25 of the image sensing chip 2 corresponding to the first solderless area 16 of the circuit substrate 1", so as to reduce the width or size of the image sensing chip in the horizontal direction.

Another beneficial effect of the present disclosure is that the image capturing module M provided by the present disclosure can adopt the technical features of "the lower surface 12 of the circuit substrate 1 including a first solder area 14 adjacent to a first side 131 of the through opening 13 and a first solderless area 16 adjacent to a second side 132 of the through opening 13", "the upper surface 21 of the image sensing chip 2 including an image sensing area 22, a first conductive area 23, and a first non-conductive area 25; the first conductive area 23 being connected between a first side 201 of the image sensing chip 2 and a first side 221 of the image sensing area 22, and the first non-conductive area 25 being connected between a second side 202 of the image sensing chip 2 and a second side 222 of the image sensing area 22", and "the first conductive area 23 of the image sensing chip 2 is electrically connected to the first solder area 14 of the circuit substrate 1 through a first solder ball 51, and the first non-conductive area 25 of the image sensing chip 2 is connected to the first solderless area 16 of the circuit substrate 1 through a first adhesive", so as to reduce the width or size of the image sensing chip in the horizontal direction.

Furthermore, compared with the related art, the image capturing module M and the portable electronic device Z of the present disclosure, has at least one side of the circuit substrate 1 and the image sensing chip 2 electrically connected to the image sensing chip 2 by providing a first solder area 14 and a first conductive area 23, so that the width or size in the horizontal direction of the at least two sides of the circuit substrate 1 and the image sensing chip 2 can be reduced. That is, since the solder area and conductive area can be omitted from at least one side of the circuit substrate 1 and the image sensing chip 2, the width of the circuit substrate 1 and the image sensing chip 2 in the horizontal direction (X direction) can be reduced. Thereby, the size of the image sensing chip 2 in the horizontal direction is reduced.

The foregoing description of the exemplary embodiments of the disclosure has been presented only for the purposes of illustration and description and is not intended to be exhaustive or to limit the disclosure to the precise forms disclosed. Many modifications and variations are possible in light of the above teaching.

The embodiments were chosen and described in order to explain the principles of the disclosure and their practical application so as to enable others skilled in the art to utilize the disclosure and various embodiments and with various modifications as are suited to the particular use contemplated. Alternative embodiments will become apparent to those skilled in the art to which the present disclosure pertains without departing from its spirit and scope.

## Claims

1. An image capturing module (M), comprising:
a circuit substrate (1) having an upper surface (11), a lower surface (12), and a through opening (13) connecting the upper surface (11) and the lower surface (12);
an image sensing chip (2) disposed on the lower surface (12) of the circuit substrate (1) and below the through opening (13);
a filter element (3) disposed on the upper surface (11) of the circuit substrate (1) and above the through opening (13);
a lens assembly (4), including a holding structure (41) disposed on the circuit substrate (1) and a lens structure (42) disposed on the holding structure (41);
wherein the lower surface (12) of the circuit substrate (1) includes a first solder area (14) adjacent to a first side (131) of the through opening (13), a second solder area (15) adjacent to a second side (132) of the through opening (13), and a first solderless area (16) adjacent to a third side (133) of the through opening (13) ;
wherein the upper surface (21) of the image sensing chip (2) includes an image sensing area (22), a first conductive area (23), a second conductive area (24), and a first non-conductive area (25); the first conductive area (23) is connected between a first side (221)first side (201) of the image sensing chip (2) and a first side (221) of the image sensing area (22), the second conductive area (24) is connected to a second side (202) of the image sensing chip (2) and a second side (222) of the image sensing area (22), and the first non-conductive area (25) is connected between a third side (203 of the image sensing chip (2) and a third side (223) of the image sensing area (22);
wherein the first conductive area (23) of the image sensing chip (2) and the second conductive area (24) are electrically and respectively connected to the first solder area (14) and the second solder area (15) of the circuit substrate (1), and the first non-conductive area (25) of the image sensing chip (2) corresponds to the first solderless area (16) of the circuit substrate (1).

2. The image capturing module (M) according to claim 1, wherein the first solder area (14) includes a plurality of first solder pad (141)s, the second solder area (15) includes a plurality of second solder pads (151), the first conductive area (23) includes a plurality of first conductive parts (231), and the second conductive area (24) includes a plurality of second conductive parts (241); the first conductive parts (231) are electrically connected to the first solder pads (141) respectively through a plurality of first solder balls (51), and the second conductive parts (241) are electrically connected to the second solder pads (151) respectively through a plurality of second solder balls (52); wherein the first solder area (14) is disposed opposite to the second solder area (15), and the first solderless area (16) is disposed between the first solder area (14) and the second solder area (15).

3. The image capturing module (M) according to claim 1, wherein the lower surface (12) of the circuit substrate (1) includes a second solderless area (17) adjacent to a fourth side (134) of the through opening (13), the upper surface (21) of the image sensing chip (2) includes a fourth side (204) connected to the image sensing chip (2) and a fourth side (224) of the image sensing area (22) a second non-conductive area (26) of the image sensing chip (2) corresponding to the second solderless area (17) of the circuit substrate (1); wherein a first adhesive is disposed on the first solderless area (16) and the first non-conductive area (25), and a second adhesive area is disposed between the second solderless area (17) and the second non-conductive area (26); wherein the first solder area (14) is opposite to the second solder area (15), the first solderless area (16) is opposite to the second solderless area (17), and the first solderless area (16) and the second solderless area (17) are disposed between the first solder area (14) and the second solder area (15).

4. The image capturing module (M) device according to claim 1, wherein lower surface (12) of the circuit substrate (1) includes a third solder area (18) adjacent to a fourth side (134) of the through opening (13), the upper surface (21) of the image sensing chip (2) includes a fourth side (204) connected to the image sensing chip (2) and a fourth side (224) of the image sensing area (22), and the third conductive area (27) of the image sensing chip (2) is electrically connected to the third solder area (18) of the circuit substrate (1); wherein the third solder area (18) includes a plurality of third solder pads (181), the third conductive area (27) includes a plurality of third conductive portions electrically connected to the third solder pads (181) respectively through a plurality of third solder balls; wherein the first solder area (14) is disposed opposite to the second solder area (15), the third solder area (18) is disposed opposite to the first solderless area (16), and the third solder area (18) and the first solderless area (16) are disposed between the first solder area (14) and the second solder area (15).

5. A portable electronic device (Z), comprising:
a portable electronic module (P);and
an image capturing module (M) disposed on the portable electronic module (P), including:
a circuit substrate (1) having an upper surface (11), a lower surface (12), and a through opening (13) connecting the upper surface (11) and the lower surface (12);
an image sensing chip (2) disposed on the lower surface (12) of the circuit substrate (1) and below the through opening (13);
a filter element (3) disposed on the upper surface (11) of the circuit substrate (1) and above the through opening (13);
a lens assembly (4), including a holding structure (41) disposed on the circuit substrate (1) and a lens structure (42) disposed on the holding structure (41);
wherein the lower surface (12) of the circuit substrate (1) includes a first solder area (14) adjacent to a first side (131) of the through opening (13), a second solder area (15) adjacent to a second side (132) of the through opening (13), and a first solderless area (16) adjacent to a third side (133) of the through opening (13) ;
wherein the upper surface (21) of the image sensing chip (2) includes an image sensing area (22), a first conductive area (23), a second conductive area (24), and a first non-conductive area (25); the first conductive area (23) is connected between a first side (201) of the image sensing chip (2) and a first side (221) of the image sensing area (22), the second conductive area (24) is connected to a second side (202) of the image sensing chip (2) and a second side (222) of the image sensing area (22), and the first non-conductive area (25) is connected between a third side (203) of the image sensing chip (2) and a third side (223) of the image sensing area (22);
wherein the first conductive area (23) of the image sensing chip (2) and the second conductive area (24) are electrically and respectively connected to the first solder area (14) and the second solder area (15) of the circuit substrate (1), and the first non-conductive area (25) of the image sensing chip (2) corresponds to the first solderless area (16) of the circuit substrate (1).

6. The portable electronic device (Z) according to claim 5, wherein the first solder area (14) includes a plurality of first solder pad (141)s, the second solder area (15) includes a plurality of second solder pad (151)s, the first conductive area (23) includes a plurality of first conductive part (231)s, and the second conductive area (24) includes a plurality of second conductive part (241)s; the first conductive part (231)s are electrically connected to the first solder pad (141)s respectively through a plurality of first solder ball (51)s, and the second conductive parts (241) are electrically connected to the second solder pad (151)s respectively through a plurality of second solder balls (52); wherein the first solder area (14) is disposed opposite to the second solder area (15), and the first solderless area (16) is disposed between the first solder area (14) and the second solder area (15).

7. The portable electronic device (Z) according to claim 5, wherein the lower surface (12) of the circuit substrate (1) includes a second solderless area (17) adjacent to a fourth side (134) of the through opening (13), the upper surface (21) of the image sensing chip (2) includes a fourth side (204) connected to the image sensing chip (2) and a fourth side (224) of the image sensing area (22), a second non-conductive area (26) of the image sensing chip (2) corresponding to the second solderless area (17) of the circuit substrate (1); wherein a first adhesive is disposed on the first solderless area (16) and the first non-conductive area (25), and a second adhesive area is disposed between the second solderless area (17) and the second non-conductive area (26); wherein the first solder area (14) is opposite to the second solder area (15), the first solderless area (16) is opposite to the second solderless area (17), and the first solderless area (16) and the second solderless area (17) are disposed between the first solder area (14) and the second solder area (15).

8. The portable electronic device (Z) according to claim 5, wherein the lower surface (12) of the circuit substrate (1) includes a third solder area (18) adjacent to a fourth side (134) of the through opening (13), the upper surface (21) of the image sensing chip (2) includes a fourth side (204) connected to the image sensing chip (2) and a fourth side (224) of the image sensing area (22), and the third conductive area (27) of the image sensing chip (2) is electrically connected to the third solder area (18) of the circuit substrate (1); wherein the third solder area (18) includes a plurality of third solder pads (181), the third conductive area (27) includes a plurality of third conductive portions electrically connected to the third solder pads (181) respectively through a plurality of third solder balls; wherein the first solder area (14) is disposed opposite to the second solder area (15), the third solder area (18) is disposed opposite to the first solderless area (16), and the third solder area (18) and the first solderless area (16) are disposed between the first solder area (14) and the second solder area (15).

9. An image capturing module (M), comprising;
a circuit substrate (1) having an (11), a lower surface (12), and a through opening (13) connecting the upper surface (11) and the lower surface (12);
an image sensing chip (2) disposed on the lower surface (12) of the circuit substrate (1) and below the through opening (13);
a filter element (3) disposed on the upper surface (11) of the circuit substrate (1) and above the through opening (13);
a lens assembly (4), including a holding structure (41) disposed on the circuit substrate (1) and a lens structure (42) disposed on the holding structure (41);
wherein the lower surface (12) of the circuit substrate (1) includes a first solder area (14) adjacent to a first side (131) of the through opening (13) and a first solderless area (16) adjacent to a second side (132) of the through opening (13);
wherein the upper surface (21) of the image sensing chip (2) includes an image sensing area (22), a first conductive area (23), and a first non-conductive area (25); the first conductive area (23) is connected to a first side (201) of the image sensing chip (2) and a first side (221) of the image sensing area (22), and the first non-conductive area (25) is connected between a second side (202) of the image sensing chip (2) and a second side (222) of the image sensing area (22);
wherein the first conductive area (23) of the image sensing chip (2) is electrically connected to the first solder area (14) of the circuit substrate (1) through a first solder ball (51), and the first non-conductive area (25) of the image sensing chip (2) is connected to the first solderless area (16) of the circuit substrate (1) through a first adhesive.

10. The image capturing module (M) device according to claim 9, wherein the lower surface (12) of the circuit substrate (1) includes a second solderless area (17) adjacent to a third side (133) of the through opening (13) and a third solderless area (19) adjacent to a fourth side (134) of the through opening (13); wherein the upper surface (21) of the image sensing chip (2) includes a second non-conductive area (26) and a third non-conductive area (28) connected to a third side (203) of the image sensing chip (2) and a third side (223) of the image sensing area (22), and the third non-conductive area (28) is connected between a fourth side (204)fourth side (204) (134) of the image sensing chip (2) and a fourth side (224) of the image sensing area (22); wherein the second non-conductive area (26) of the image sensing chip (2) is connected to the second solderless area (17) of the circuit substrate (1) through a second adhesive, and the third non-conductive area (28) of the image sensing chip (2) is connected to the third solderless area (19) of the circuit substrate (1) through a third adhesive.
